(19) Europäisches Patentamt

European Patent Office

Office européen des brevets

(11) **EP 1 395 688 B1**

(12) **EUROPEAN PATENT SPECIFICATION**

(45) Date of publication and mention
of the grant of the patent:
**12.05.2010 Bulletin 2010/19**

(51) Int Cl.:
*C23C 14/00* (2006.01)    *C23C 14/08* (2006.01)
*C23C 14/46* (2006.01)    *G01K 17/00* (2006.01)
*G01J 5/20* (2006.01)

(21) Application number: **01941781.5**

(22) Date of filing: **01.06.2001**

(86) International application number:
**PCT/US2001/017755**

(87) International publication number:
**WO 2002/099155 (12.12.2002 Gazette 2002/50)**

(54) **ION BEAM SPUTTER DEPOSITION PROCESS AND APPARATUS**

VERFAHREN UND VORRICHTUNG ZUR IONENSTRAHL-SPUTTERBESCHICHTUNG

PROCEDE ET DISPOSITIF DE DEPOT PAR PULVERISATION IONIQUE

(84) Designated Contracting States:
**AT BE CH CY DE DK ES FI FR GB GR IE IT LI LU
MC NL PT SE TR**

(43) Date of publication of application:
**10.03.2004 Bulletin 2004/11**

(73) Proprietor: **Honeywell International Inc.
Morristown NJ 07960 (US)**

(72) Inventors:
• **COLE, Barrett, E.
Bloomington, MN 55431 (US)**
• **ZINS, Christopher, J.
Inver Grove Heights, MN 55077 (US)**

(74) Representative: **Smee, Anthony James Michael
Gill Jennings & Every LLP
Broadgate House
7 Eldon Street
London EC2M 7LH (GB)**

(56) References cited:
**US-A- 4 166 784        US-A- 5 286 976
US-A- 5 801 383        US-A- 6 121 618
US-A1- 2001 035 341**

• **CEVRO M ET AL: "ION BEAM SPUTTERING AND
DUAL ION BEAM SPUTTERING OF TITANIUM
OXIDE FILMS" JOURNAL OF PHYSICS D.
APPLIED PHYSICS, IOP PUBLISHING, BRISTOL,
GB, vol. 28, no. 9, 14 September 1995
(1995-09-14), pages 1962-1976, XP000528777
ISSN: 0022-3727**
• **CHAIN E E: "EFFECTS OF OXYGEN IN ION-BEAM
SPUTTER DEPOSITION OF VANADIUM OXIDE"
JOURNAL OF VACUUM SCIENCE AND
TECHNOLOGY: PART A, AMERICAN INSTITUTE
OF PHYSICS. NEW YORK, US, vol. 5, no. 4, PART
3, 1 July 1987 (1987-07-01), pages 1836-1839,
XP000036364 ISSN: 0734-2101**
• **MASAAKI YOSHITAKE ET AL: "THE USE OF THE
ION BEAM CURRENT AS A PROCESS CONTROL
IN THE REACTIVE SPUTTERING OF ZIRCONIUM
OXIDE" THIN SOLID FILMS, ELSEVIER-SEQUOIA
S.A. LAUSANNE, CH, vol. 230, no. 1, 15 July 1993
(1993-07-15), pages 48-54, XP000381802 ISSN:
0040-6090**
• **YONG-SU OH ET AL: "PREPARATION OF
VANADIUM OXIDE THIN FILMS BY RADIO-
FREQUENCY MAGNETRON SPUTTERING"
JOURNAL OF THE CERAMIC SOCIETY OF
JAPAN, INTERNATIONAL EDITION, FUJI
TECHNOLOGY PRESS, TOKYO, JP, vol. 100, no.
12, 1 December 1992 (1992-12-01), pages
1371-1373, XP000303690 ISSN: 0912-9200**

## Description

### Background of the Invention

The present invention pertains to microbolometer sensors and particularly to methods for producing detector material for microbolometers. More particularly, the invention pertains to a particular detector material which is fabricated from a special ion beam sputter deposition process. The U.S. Government has certain rights in the present invention.

A major factor in the sensitivity of a bolometer is the TCR (thermal coefficient of resistance, often expressed in %/°C) of the detector material. The overall NETD (noise equivalent temperature difference) sensitivity of the bolometer also depends on the noise level. Previous bolometer materials are typically high TCR metals with a TCR in the range from 0.003 to 0.004. These materials have low noise but also have low TCR. Since the metals are reflectors, they also degrade the absorbance properties of the detector. Materials which undergo a phase transition (i.e., Mott transition) can have very high TCR's in the transition region but can suffer from a number of problems. First, the latent heat accompanying the phase change for these materials may significantly decrease the sensitivity of the detector. Second, most switching material can be produced in only one form without additional doping, which defines the material resistance and TCR. Further, the temperature range over which the transition occurs is typically very small, requiring tight temperature control of the operation. Finally, the films must be produced in crystalline form which requires high temperature depositions.

### Summary of the Invention

Chain E E: "Effects of oxygen in ion-beam sputter deposition of vanadium oxide" Journal of Vacuum Science and Technology: Part A, American Institute of Physics. New York, US, vol. 5, no. 4, Part 3, 1 July 1987, pages 1836-1839, XP000036364 ISSN: 0734-2101 and Cevro M et al: "Ion beam sputtering and dual ion beam sputtering of titanium oxide films" Journal of Physics D. Applied Physics, IOP Publishing, Bristol, GB, vol. 28, no. 9, 14 September 1995, pages 1962-1976, XP000528777 ISSN: 0022-3727 and Masaaki Yoshitake et al: "The use of the ion beam current as a process control in the reactive sputtering of zirconium oxide" Thin Solid Films, Elsevier-Sequoia S.A. Lausanne, CH, vol. 230, no. 1, 15 July 1993 (1993- 07-15), pages 48-54, XP000381802 ISSN: 0040-6090 disclose methods for depositing oxide materials in an ion beam sputter deposition process in which a partial pressure of oxygen in the chamber is controlled during the sputtering of the target, wherein a material having a non-stoichiometric composition is deposited.

Such a method as given in claim 1, is, according to the present invention, characterised by a process of conditioning the target including the steps of

pre-sputtering the target with oxygen; setting a first oxygen flow rate into the chamber and measuring a first oxygen partial pressure corresponding to the first oxygen flow rate; increasing the oxygen flow rate incrementally to a second oxygen flow rate and recording a second oxygen partial pressure corresponding to the second oxygen flow rate; and comparing the first oxygen partial pressure to the second oxygen partial pressure; and determining that the second oxygen partial pressure is greater than the first oxygen partial pressure; and setting an oxygen partial pressure setpoint between the first oxygen partial pressure and the second oxygen partial pressure for determining the starting level of oxygen flow for deposition of the oxide material.

In other embodiments, the detector material may be any material formed by reacting two or more species wherein at least one of the species is in gas phase. The x of VOx is a value fitting for the pixel being sputter deposited by the present process and is not necessarily a specific digit such as "2," but may be between 1 and 2.5. That material is deposited as part of a pixel for a high performance microbolometer. The material is deposited as part of a pixel for a high performance microbolometer detectors. These detector materials have optical, electrical, and thermal properties compatible with high performance detectors but which can be readily modified to suit individual requirements of an array design.

### Brief Description of the Drawings

Figure 1 reveals a TCR comparison of various materials, including ABx, e.g., VOx.
Figure 2 is a graph showing electrical characteristics of a high TCR ABx, e.g., VOx, detector film.
Figure 3 exhibits determination of VOx resistance by control of the deposition environment.
Figure 4a and 4b are a schematic of the deposition system.
Figure 5 is a schematic of the deposition process flow.
Figure 6a and 6b show several stages of the deposited wafer.

### Description of the Preferred Embodiments

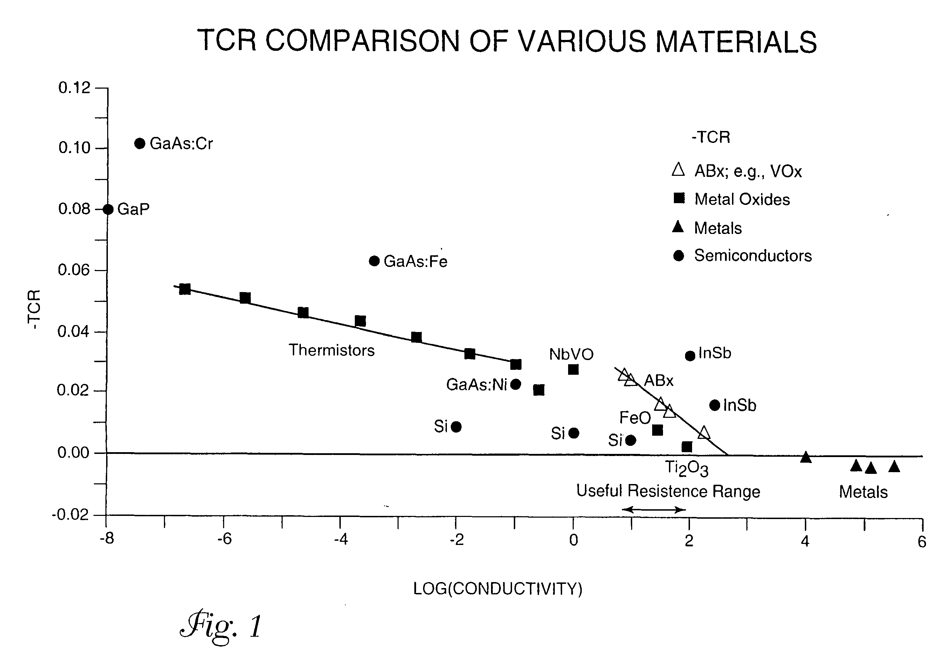

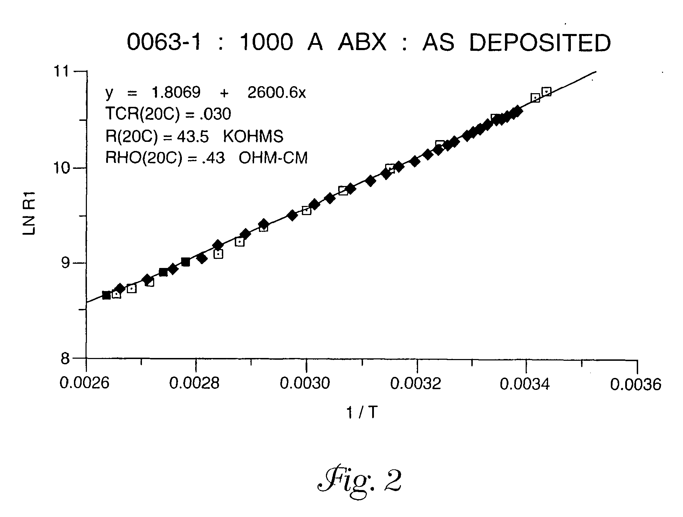

VOx deposited by a controlled ion beam sputtering process has produced bolometer detector films with a wide range of performance properties which has led to a flexible detector manufacturing process. Some of the advantages of the present detector film materials of the invention, which is the class of these materials and the processing used to make these materials, are noted. Bolometer film materials with high TCR's ranging from 0.005 to > 0.03, such as 0.05, have been demonstrated. For a given resistivity, these materials are higher performing in microbolometers than any known material except for a few crystalline materials (which have not been produced on pixels), as shown in Figure 1. Figure 1 is a graph showing a comparison of the TCR versus conductivity of various materials relative to ABx (e.g., VOx). This class of materials may have an empirically-determined relationship between resistance and TCR given by the relationship TCR = C + D * log(conductivity) (where "C" and "D" are constants) which, for example, may be TCR = -(0.03 - 0.01 * log(conductivity)). A wide range of pixel resistance and TCR properties are possible by using different resistivity materials (obtained by slight modifications to the deposition process) combined with different detector patterns and thicknesses. These electrical properties for any particular VOx film are well-behaved and characterized over a wide range of temperatures and are not limited to a narrow transition region, as indicated by Figure 2. For any particular VOx film, resistance is given by Ln(R) = E + (F/T) (where "E" and "F" are constants and "T" is the temperature) and the TCR which is defined

as $\dfrac{1}{R}\dfrac{dR}{dT}$ is therefore TCR = $-F/T^2$. Figure 2 exhibits

the electrical characteristics of a high TCR VOx detector film. These characteristics reveal a material having a well-behaved operation over a wide temperature range. Resistance levels are in the proper range to permit high current bolometer operation for optimal responsivity. The films are amorphous and exhibit no latent heat effects, unlike the phase transition effects in VO2. The films are stable after annealing if not taken to a higher temperature. The resistance change on annealing is well-defined and can be corrected for by changes to the initial deposition conditions. 1/f noise levels are defined by

$$V_{noise} = V_{bias}\sqrt{\dfrac{k}{f}}.$$ k values as low as $10^{-12}$ to $10^{-14}$

make 1/f noise contributions to total noise very small. Noise levels are close to Johnson noise limited values.

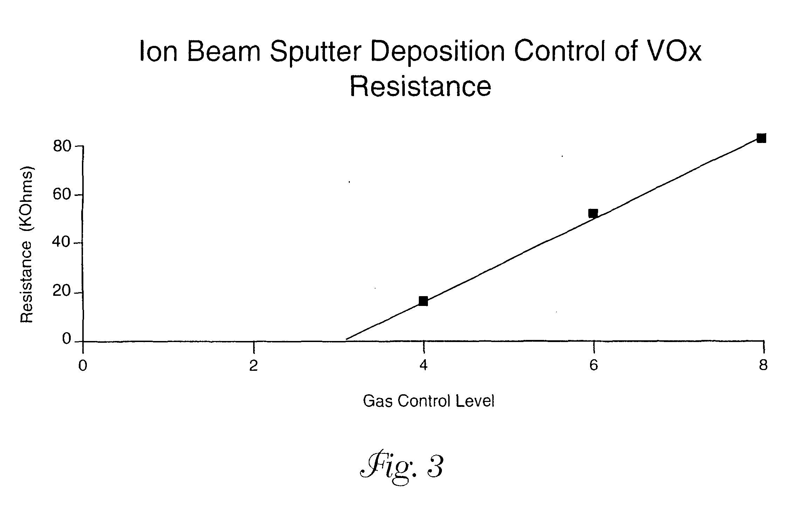

The optical properties of VOx are compatible with high absorbance in the detector. The thermal mass of VOx, the thermal property of importance, is comparable to the major pixel material, e.g., Si3N4. These VOx films have a high TCR over a range of thicknesses from as low as a few hundred Angstroms (Å) to as thick as 1500 Å. This material of the films is compatible with microbolometer properties. The VOx material properties can readily be modified by a simple change in the ion beam sputter deposition environment of the process of the present invention, as revealed by Figure 3. Figure 3 is a graph that shows determination of VOx resistance by control of the ion beam sputter deposition environment such as the gas control level. The present ion beam sputtering provides sufficient control of the oxidation process to permit non-stoichiometric formation of VOx films. In other reactive deposition techniques, the oxidation process tends to proceed to completion forming only stoichiometric material. The ion beam sputter deposition is a lower temperature deposition process. This means that added flexibility in the patterning of VOx films can be achieved via liftoff processing which entails the use of photoresist during deposition.

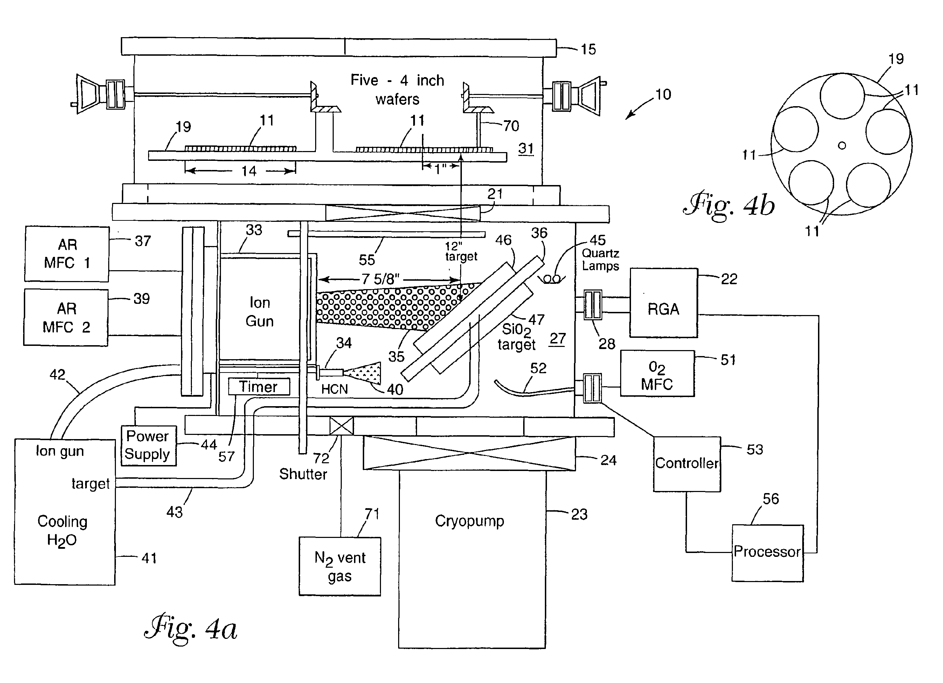

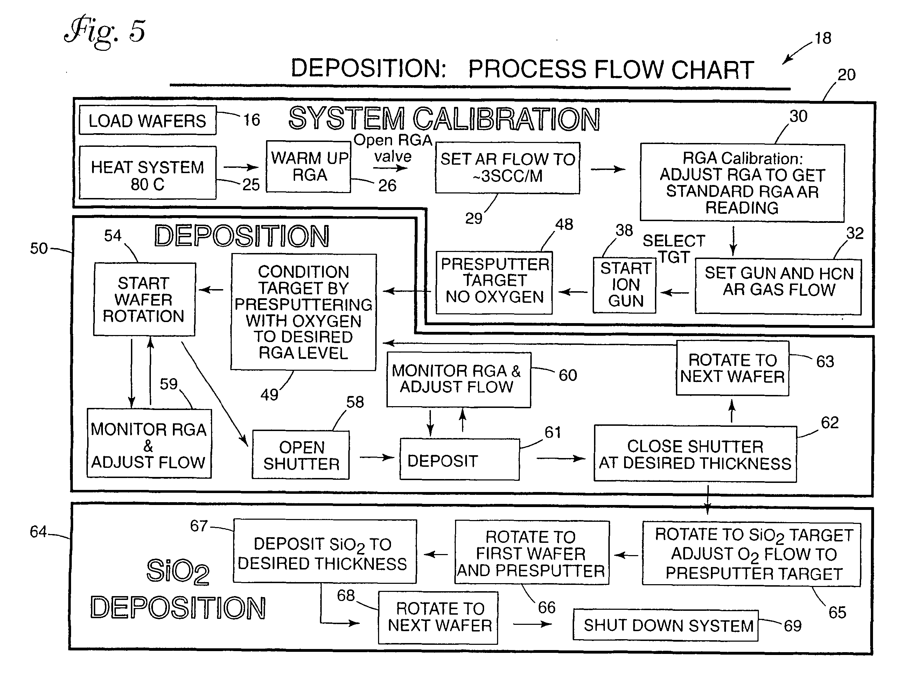

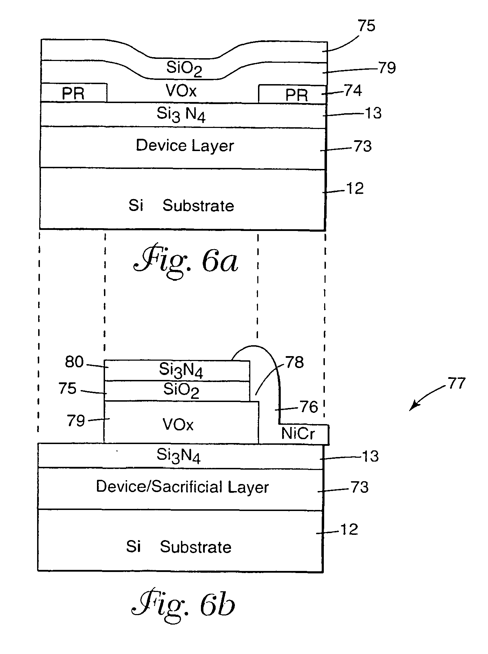

The method of the present invention is a process 18 of Figure 5, performed in conjunction with deposition 10 of Figure 4a, which is capable of making the above-noted VOx material. Circular silicon wafers 11 with substrates containing electronic circuits and pixel lower layers 12 (see Figure 6a) which are coated with an approximately 5000 Å Si3N4 layer 13, are loaded into a five-wafer carousel 19 (of Figures 4a and 4b) through port 15 of deposition apparatus 10. Also, photoresist 74 (see also Figure 6a) may be on wafer 11 which defines pixels. At present, each wafer 11 has a diameter 14 of four inches. Wafer 11 loading is step 16 of process 18 flowchart. System 10 is first calibrated according to calibration stage 20 of process 18, which involves pumping the system down to $2 \times 10^{-7}$ Torr pressure. The vacuum system is capable of pumping to base pressure less than $1 \times 10^{-7}$ Torr, with a throughput of better than an eight inch two-stage cyropump 23 via valve 24. System 10 is pumped down by opening valve 21 which is left open during the process. System 10 may be warmed up at step 25 with lamps 45. A residual gas analyzer (RGA) 22 is warmed up at step 26 before the process calibration. RGA 22 is connected to chamber 27 and has a quadruple probe which has an electron multiplier (EM) detector in a turbo-pumped sampling manifold to allow for operation in the $10^{-7}$ Torr pressure environment. RGA 22 may be connected to either upper chamber 31 or lower chamber 27. RGA 22 has an analog output.

Silicon wafers 11 may be anything with active electrons on it, such as CMOS or bipolar devices 73 of Figures 6a and 6b, or other kinds of detector components up to the Si3N4 layer 13, photoresist 74, and/or VOx layer 79 deposition. RGA 22 valve 28 is opened and argon flow is set to approximately 3 scc/m at stage 29 of process 18. RGA 22 is calibrated via an adjustment of its gain to get a standard RGA argon reading at step 30. RGA 22 is a closed source device. It is connected to chamber 27 in Figure 4a. The output of RGA 22 detects a spectrum of species of gas constituents and the detected gases are identified. RGA 22 is pumped out so that the pressure in RGA 22 is lower than chamber 27, and the ion species have to go through a small orifice at valve 28. RGA 22 is made by UTI Inc. With RGA 22 valve open, the argon gas flow reading is set for calibrating RGA 22 to a known argon peak level.

At step 32, the argon gas flow is set for gun 33 and hollow cathode neutralizer (HCN) 34. Gun 33 uses argon as a sputtering gas. Ion beam 35 is neutralized by beam 40 of HCN 34. The ion gun is from Ion Tech Inc.

A target on target holder 36 is positioned relative to gun 33 beam 35 so that vanadium is selected as a target material 46. The other side of target holder has SiO2 as a selectable target material 47. The target material is set at a 45 to 55 degree angle relative to the direction of beam 35. The center of the target material is at a distance of 7 and 5/8 inches from the beam 35 exit of gun 33. Argon gas How to gun 33 is set with MFC 37 to a 2.5 scc/m operating level, and to HCN 34 set with MFC 39 to a 3.5 scc/m operating level. Xenon (Xe) may also be used in place of Argon (Ar). Cooling water from source 41 is turned on to gun 33 via line 42 and to target holder 36 via line 43. At step 38, an ion gun power supply 44 is turned on and the initial gun start-up parameters are set to 20 mA at 1 kV. The ion gun source is turned on and the source stabilizes. Beam 35 of ion gun 33 is turned on. The power supply voltages are adjusted. There is plasma in gun 33 and ion beam 35 is generated or accelerated through grids of gun 33.

At next step 48, target material 46 is pre-sputtered with no oxygen. Preheat system quartz lamps 45 are turned off, if on. Target material 46 is pre-sputtered for 240 seconds at the low power of 20 mA at 1 kV. During the next 240 seconds, target 46 is pre-sputtered at the medium power of 35 mA at 1.5 kV. Pre-sputter continues for the next 120 seconds at the high power of 50 mA at 2 kV, which concludes system calibration stage 20. The pre-sputter without oxygen is for cleaning target 46 for ten minutes or so.

The following stage 50 begins with step 49 of pre-sputter with an oxygen ramp to condition target 46 to a desired RGA 22 level. The oxygen goes up by little steps and then to larger steps as one measures the oxygen within system 18. This is not cleaning target 46 but conditioning target 46 to the desired RGA 22 level. One increases the oxygen to get a character profile for film 79 based on past experience and RGA 22 is set at an arbitrary level called y. The beam 35 power is kept at 50 mA at 2 kV and controller 53 of MFC 51 sets the oxygen flow to chamber 27 via tube 52 to 0.5 scc/m for 90 seconds. Then, the oxygen flow is increased by 0.1 scc/m for 90 seconds. The latter is repeated until the 32 AMU ($O_2$ atomic weight) partial pressure increase is equal to or greater than ten times over the previous partial pressure. The operating level setpoint is based on the partial pressure rise of the previous step which is about midpoint of the last 32 AMU partial pressure increase. The precise location of the operating setpoint determines the resistance and TCR. The 32 AMU partial pressure setpoint is entered into controller 53, which determines the level of oxygen flow for VOx film 79 deposition. One increases the flow of oxygen in an incremental way until $O_2$ is at a point where the RGA outputs an $O_2$ signal. One measures the mass and monitors the RGA $O_2$. Ion gun 33 is run at a set level with a fixed voltage and current. Monitoring of RGA 22 of 32 AMU is done at controller 53 where the flow is adjusted to achieve the starting level. A computer processor 56 may be used at step 59 to monitor RGA 22 and adjust the oxygen flow via controller 53 to achieve starting condition or level.

At step 54, rotation of wafer substrate 11 is started. A control loop is started with a pre-sputter for 300 seconds at the setpoint of controller 53. A shutter 55 is opened at step 58 after system 10 has stabilized. A timer 57 is started, with the time determined by a desired thickness, of which the deposition rate is approximately at 2.5 Å per second. RGA 22 may be monitored and oxygen flow adjusted at step 60 during deposition step 61. The center of sputtered target 46, with its surface at 45-55° relative to and 12 inches from the to-be-deposited surface of wafer 11, is aligned at one inch from the center of wafer 11. After the desired thickness is achieved, then shutter 55 is closed at step 62. Then, carousel 19 is turned at step 63 for the next wafer 11 to be coated, the control loop starts with the pre-sputter at step 49 of deposition stage 50, and goes through the same steps of the process for the previous wafer 11 deposition. After all the substrates 11 of carousel are deposited, the control loop of stage 50 is stopped. The oxygen MFC 51 is set to zero scc/m, RGA 22 sample valve 28 is closed, ion beam 35 is turned off or to stand-by mode, and RGA 22 is turned off.

Process 18 is a low temperature process which does not go over 100°C, which would cause photoresist 74 to harden. Typically, this process is performed at about 80°C or less.

Process 18 for wafers 11 moves on to stage 64 for SiO2 deposition. At step 65, target holder 36 is rotated so that the surface of target 47 will be at a 45° angle relative to the direction at the center of ion beam 35 when it is turned on, and the oxygen flow is set to 2.0 scc/m at MFC 51. First, wafer 11 is rotated by carousel 19 as step 66. Ion gun 33 is turned on at 50 mA at 2 kV to pre-sputter target 47 for 300 seconds. Shutter 55 is opened, and timer 57 is started. Timer 57 is set to a time period to attain a desired thickness of $SiO_2$ on wafer 11 at a deposition rate of 0.33 Å per second at step 67. Then, shutter 55 is closed. Next, wafer 11 is rotated by carousel 19 for SiO2 deposition at step 68, and steps for depositing SiO2 on previous wafer 11 are followed. After the last wafer 11 is coated with deposition of SiO2, the system 10 is shut down at step 69 of stage 64. Ion beam 35 is turned off, MFC 51 is set to 0.0 scc/m, ion beam source 33 is turned off, and substrate rotator 70 and carousel 19 are turned off. One should wait and let system 10 cool down for 45 minutes. After cool-down, Hivac valve 24 is closed and system 10 is vented with dry N2 from supply 71 through valve 72. One may open system 10 when it is at atmospheric pressure and remove wafers 11. To start process 18 over with another set of substrates or wafers 11, one introduces wafers 11 into upper chamber 31 through port 15 and closes system 10. Quartz lamps 45 are turned on to a preset level to yield 80°C temperatures in system 10. N2 vent gas valve 72 is turned off and MFC 37 and MFC 39 are set to 0.0 scc/m. Next, pump down with cyropump 23 and open Hivac valve 24. Check for leaks and go through process 18 as indicated above. The values of the parameters and settings of the above-noted embodiments are by example only, but could vary from case to case.

From wafer 11, processed by system 10, is made microbolometer pixels 77 of Figures 6a and 6b. On wafer 11, prior to system 10 depositions of VOx and SiO2, may be Si substrate 12 covered with a device layer 73. On layer 73 is pixel Si3N4 material layer 13. Pixels 77 are defined with a photoresist mask 74. Then, VOx layer 79 and SiO2 layer 75 are respectively deposited on wafer 11, as indicated above and revealed in Figure 6a. The next step is to chemically remove photoresist 74, and a portion of layers 79 and 75 formed on and over photoresist layer is likewise removed, resulting in pixel 77 as shown in Figure 6b. A via or hole 78 is etched through layer 75 for electrical contact which is made with a nichrome (NiCr) strip 76 formed by depositing and patterning on a small portion of pixel 77. NiCr 76 forms the contact to the VOx portion of pixel 77. VOx layer 79 covers a major portion of pixel 77. An additional Si3N4 layer may be formed on pixel 77 of Figure 6b for more protection. Layer 75 is about 200 Å. If layer 75 were not put on prior to placement of contact 76, then the VOx portion of the pixel would be degraded due to the electrical degradation of VOx during pre-sputter of the film prior to Si3N4 and subsequent NiCr deposition of strip 76. Layer 79 may range from 200-2000 Å depending on the desired TCR. Layer 13 is about 500 Å. But if an Si3N4 layer 80 is formed on layer 75, then NiCr strip would go through layer 80 and layer 75 to contact VOx layer 79.

**Claims**

1. A method for depositing an oxide material in an ion beam sputter deposition process in a chamber (27), the method comprising:

   conditioning a target (46) in the chamber (27);
   sputtering the target with ions in the chamber (27) containing oxygen; and
   controlling a partial pressure of the oxygen in the chamber during the sputtering of the target, wherein a material having a non-stoichiometric composition (79) is deposited;

   **characterized in that** conditioning the target comprises:

   pre-sputtering the target (46) with oxygen;
   setting a first oxygen flow rate into the chamber and measuring a first oxygen partial pressure corresponding to the first oxygen flow rate;
   increasing the oxygen flow rate incrementally to a second oxygen flow rate and recording a second oxygen partial pressure corresponding to the second oxygen flow rate; and

   comparing the first oxygen partial pressure to the second oxygen partial pressure; and
   determining that the second oxygen partial pressure is greater than the first oxygen partial pressure; and
   setting an oxygen partial pressure setpoint between the first oxygen partial pressure and the second oxygen partial pressure for determining the starting level of oxygen flow for deposition of the oxide material.

2. The method of claim 1, wherein controlling the partial pressure of the oxygen in the chamber comprises:

   detecting the partial pressure of the oxygen in the chamber with a residual gas analyzer; and
   adjusting a flow of oxygen into the chamber in response to the partial pressure detected by the residual gas analyzer.

3. The method of claim 2, wherein the oxygen partial pressure setpoint corresponds to about half the difference between the first oxygen partial pressure and the second oxygen partial pressure.

4. The method of claim 1, wherein conditioning the target further comprises:

   determining that the second oxygen partial pressure is less than about ten times the first oxygen partial pressure; and
   increasing the oxygen flow rate incrementally to a third oxygen flow rate and recording a third oxygen partial pressure corresponding to the third oxygen flow rate.

5. The method of any one of claims 1 to 4, wherein the reactive target comprises vanadium.

6. The method of any one of claims 1 to 5, wherein the ions are argon ions.

7. The method of any one of claims 1 to 6, wherein the ions are selected from the group VIII of the periodic table of elements.

8. The method of any one of claims 1 to 7, wherein:

   the material (79) deposited is VOx; and
   x is a value such that a thermal coefficient of resistance is between 0.005 and 0.05.

9. The method of claim 8, wherein the VOx has a log of conductivity between zero and three.

10. An apparatus for use in the method of claim 1, the apparatus comprising:

a chamber (27) having an ion beam source (33) therein; and

a residual gas analyzer (22) coupled to the chamber;

a computer processor (56) connected to the residual gas analyzer; and

a controller (53) connected to the processor, wherein the computer processor monitors the residual gas analyzer and adjusts a mass flow rate of oxygen into the chamber via the controller based on a partial pressure of oxygen measured by the residual gas analyzer.

11. The apparatus of claim 10 further comprising a reactive target of vanadium located within the chamber.

12. The apparatus of any one of claims 10 or 11, further comprising an argon source (37) coupled to the ion gun.

13. The apparatus of any one of claims 10 to 12, wherein the apparatus is operable to deposit a VOx material, wherein x is a value such that a thermal coefficient of resistance is between 0.005 and 0.05.

14. The apparatus of claim 13, wherein the VOx has a log of conductivity between zero and three.

**Patentansprüche**

1. Verfahren zum Abscheiden eines Oxidmaterials in einem Ionenstrahlsputterabscheidungsprozeß in einer Kammer (27), wobei das Verfahren folgendes umfaßt:

Konditionieren eines Targets (46) in der Kammer (27),

Sputtern des Target mit Ionen in der Sauerstoff enthaltenden Kammer (27) und Steuern eines Partialdrucks des Sauerstoffs in der Kammer während des Sputtern des Targets, wobei ein Material mit einer nicht-stöchiometrischen Zusammensetzung (79) abgeschieden wird;

**dadurch gekennzeichnet, daß** das Konditionieren des Targets folgendes umfaßt:

Vorsputtern des Targets (46) mit Sauerstoff;
Einstellen einer ersten Sauerstoffströmungsrate in die Kammer und Messen eines der ersten Sauerstoffströmungsrate entsprechenden ersten Sauerstoffpartialdrucks;
inkrementelles Erhöhen der Sauerstoffströmungsrate auf eine zweite Sauerstoffströmungsrate und Aufzeichnen eines der zweiten Sauerstoffströmungsrate entsprechenden zweiten Sauerstoffpartialdrucks und
Vergleichen des ersten Sauerstoffpartialdrucks mit dem zweiten Sauerstoffpartialdruck und
Bestimmen, daß der zweite Sauerstoffpartialdruck größer ist als der erste Sauerstoffpartialdruck und
Einstellen eines Sauerstoffpartialdrucksollwerts zwischen dem ersten Sauerstoffpartialdruck und dem zweiten Sauerstoffpartialdruck zum Bestimmen des Startpegels der Sauerstoffströmung für die Abscheidung des Oxidmaterials.

2. Verfahren nach Anspruch 1, wobei das Steuern des Partialdrucks des Sauerstoffs in der Kammer folgendes umfaßt:

Detektieren des Partialdrucks des Sauerstoffs in der Kammer mit einem Restgasanalysator und
Justieren einer Sauerstoffströmung in die Kammer als Reaktion auf den von dem Restgasanalysator detektierten Partialdruck.

3. Verfahren nach Anspruch 2, wobei der Sauerstoffpartialdrucksollwert etwa der Hälfte der Differenz zwischen dem ersten Sauerstoffpartialdruck und dem zweiten Sauerstoffpartialdruck entspricht.

4. Verfahren nach Anspruch 1, wobei das Konditionieren des Targets weiterhin folgendes umfaßt:

Bestimmen, daß der zweite Sauerstoffpartialdruck kleiner ist als etwa das zehnfache des ersten Sauerstoffpartialdrucks und
inkrementelles Erhöhen der Sauerstoffströmungsrate zu einer dritten Sauerstoffströmungsrate und Aufzeichnen eines der dritten Sauerstoffströmungsrate entsprechenden dritten Sauerstoffpartialdrucks.

5. Verfahren nach einem der Ansprüche 1 bis 4, wobei das reaktive Target Vanadium umfaßt.

6. Verfahren nach einem der Ansprüche 1 bis 5, wobei die Ionen Argonionen sind.

7. Verfahren nach einem der Ansprüche 1 bis 6, wobei die Ionen ausgewählt sind aus der Gruppe VIII der Tafel des Periodensystems der Elemente.

8. Verfahren nach einem der Ansprüche 1 bis 7, wobei:

das abgeschiedene Material (79) VOx ist und x ein Wert derart ist, daß ein thermischer Widerstandskoeffizient zwischen 0,005 und 0,05 liegt.

9. Verfahren nach Anspruch 8, wobei das VOx einen log der Leitfähigkeit zwischen null und drei aufweist.

**10.** Vorrichtung zur Verwendung bei dem Verfahren von Anspruch 1, wobei die Vorrichtung folgendes umfaßt:

eine Kammer (27) mit einer Ionenstrahlquelle (33) darin und

einen an die Kammer gekoppelten Restgasanalysator (22);

einen mit dem Restgasanalysator verbundenen Computerprozessor (56) und

einen mit dem Prozessor verbundenen Controller (53), wobei der Computerprozessor den Restgasanalysator überwacht und eine Massenströmungsrate von Sauerstoff in die Kammer über den Controller auf der Basis eines von dem Restgasanalysator gemessenen Sauerstoffpartialdrucks einstellt.

**11.** Vorrichtung nach Anspruch 10, weiterhin umfassend ein innerhalb der Kammer angeordnetes reaktives Target aus Vanadium.

**12.** Vorrichtung nach einem der Ansprüche 10 oder 11, weiterhin umfassend eine an die Ionenkanone gekoppelte Argonquelle (37).

**13.** Vorrichtung nach einem der Ansprüche 10 bis 12, wobei die Vorrichtung betätigt werden kann, ein VOx-Material abzuscheiden, wobei x ein Wert derart ist, daß ein thermischer Widerstandskoeffizient zwischen 0,005 und 0,05 liegt.

**14.** Vorrichtung nach Anspruch 13, wobei das VOx einen log der Leitfähigkeit zwischen null und drei aufweist.

## Revendications

**1.** Procédé pour déposer une matière d'oxyde dans un procédé de dépôt par pulvérisation ionique dans une chambre (27), le procédé comprenant les étapes suivantes:

conditionner une cible (46) dans la chambre (27),

pulvériser la cible avec des ions dans la chambre (27) contenant de l'oxygène; et

commander une pression partielle d'oxygène dans le chambre pendant la pulvérisation de la cible, dans lequel une matière présentant une composition non stoechiométrique (79) est déposée;

**caractérisé en ce que**:

le conditionnement de la cible comprend les étapes suivantes:

pré-pulvériser la cible (46) avec de l'oxygène;

régler un premier débit d'oxygène dans la chambre et mesurer une première pression partielle d'oxygène qui correspond au premier débit d'oxygène;

augmenter le débit d'oxygène de façon incrémentielle jusqu'à un deuxième débit d'oxygène, et enregistrer une deuxième pression partielle d'oxygène qui correspond au deuxième débit d'oxygène; et

comparer la première pression partielle d'oxygène avec la deuxième pression partielle d'oxygène; et

déterminer que la deuxième pression partielle d'oxygène est supérieure à la première pression partielle d'oxygène; et

fixer un point de consigne de pression partielle d'oxygène qui se situe entre la première pression partielle d'oxygène et la deuxième pression partielle d'oxygène afin de déterminer le niveau de départ d'un écoulement d'oxygène pour le dépôt de la matière d'oxyde.

**2.** Procédé selon la revendication 1, dans lequel la commande de la pression partielle de l'oxygène dans la chambre comprend:

la détection de la pression partielle de l'oxygène à l'aide d'un analyseur de gaz résiduel; et

le réglage d'un écoulement d'oxygène dans la chambre en réponse à la pression partielle détectée par l'analyseur de gaz résiduel.

**3.** Procédé selon la revendication 2, dans lequel le point de consigne de la pression partielle d'oxygène correspond à environ la moitié de la différence entre la première pression partielle d'oxygène et la deuxième pression partielle d'oxygène.

**4.** Procédé selon la revendication 1, dans lequel le conditionnement de la cible comprend en outre:

la détermination que la deuxième pression partielle d'oxygène est inférieure à environ dix fois la première pression partielle d'oxygène; et

l'augmentation du débit d'oxygène de façon incrémentielle jusqu'à un troisième débit d'oxygène, et l'enregistrement d'une troisième pression partielle d'oxygène qui correspond au troisième débit d'oxygène.

**5.** Procédé selon l'une quelconque des revendications 1 à 4, dans lequel la cible réactive contient du vanadium.

**6.** Procédé selon l'une quelconque des revendications 1 à 5, dans lequel les ions sont des ions argon.

7. Procédé selon l'une quelconque des revendications 1 à 6, dans lequel les ions sont sélectionnés dans le groupe VIII du tableau périodique des éléments.

8. Procédé selon l'une quelconque des revendications 1 à 7, dans lequel:

   la matière (79) déposée est du $VO_x$; et
   x est une valeur telle qu'un coefficient thermique de résistance soit compris entre 0,005 et 0,05.

9. Procédé selon la revendication 8, dans lequel le $Vo_x$ présente un logarithme de la conductivité compris entre zéro et trois.

10. Dispositif à utiliser dans le procédé selon la revendication 1, le dispositif comprenant:

    une chambre (27) comprenant une source de faisceau d'ions (33) dans celle-ci; et
    un analyseur de gaz résiduel (22) couplé à la chambre;
    un processeur d'ordinateur (56) connecté à l'analyseur de gaz résiduel; et
    un dispositif de commande (53) connecté au processeur, dans lequel le processeur d'ordinateur surveille l'analyseur de gaz résiduel et règle un débit massique d'oxygène dans la chambre par l'intermédiaire du dispositif de commande sur la base d'une pression partielle d'oxygène mesurée par l'analyseur de gaz résiduel.

11. Dispositif selon la revendication 10, comprenant en outre une cible réactive de vanadium située à l'intérieur de la chambre.

12. Dispositif selon l'une quelconque des revendications 10 ou 11, comprenant en outre une source d'argon (37) couplée au canon à ions.

13. Dispositif selon l'une quelconque des revendications 10 à 12 dans lequel le dispositif peut être utilisé pour déposer une matière de $VO_x$, dans lequel x est une valeur telle qu'un coefficient thermique de résistance soit compris entre 0,005 et 0,05.

14. Dispositif selon la revendication 13, dans lequel le $VO_x$ présente un logarithme de la conductivité compris entre zéro et trois.

# TCR COMPARISON OF VARIOUS MATERIALS

*Fig. 1*

0063-1 : 1000 A ABX : AS DEPOSITED

y = 1.8069 + 2600.6x
TCR(20C) = .030
R(20C) = 43.5 KOHMS
RHO(20C) = .43 OHM-CM

*Fig. 2*

EP 1 395 688 B1

## Ion Beam Sputter Deposition Control of VOx Resistance

Fig. 3

Five - 4 inch wafers

15

19

11

11

70

31

14

1"

21

10

AR MFC 1 — 37

AR MFC 2 — 39

33

Ion Gun

55

12" target

46

36

45 Quartz Lamps

22 RGA

7 5/8"

47

SiO₂ target

27

28

52

51 O₂ MFC

42

34

35

40

HCN

Ion gun

Power Supply

Timer

target

44

57

72

Shutter

71 N₂ vent gas

24 Cryopump

23

53 Controller

Cooling H₂O

41

43

56 Processor

*Fig. 4a*

*Fig. 4b*

EP 1 395 688 B1

# Fig. 5

## DEPOSITION: PROCESS FLOW CHART 18

### SYSTEM CALIBRATION 20

LOAD WAFERS — 16

HEAT SYSTEM 80 C → WARM UP RGA → (Open RGA valve) SET AR FLOW TO ~3SCC/M → RGA Calibration: ADJUST RGA TO GET STANDARD RGA AR READING 30

25 / 26 / 29 / 32

SELECT TGT

PRESPUTTER TARGET NO OXYGEN 48 ← START ION GUN 38 ← SET GUN AND HCN AR GAS FLOW

### DEPOSITION 50

START WAFER ROTATION 54 ← CONDITION TARGET BY PRESPUTTERING WITH OXYGEN TO DESIRED RGA LEVEL 49

MONITOR RGA & ADJUST FLOW 59

MONITOR RGA & ADJUST FLOW 60

ROTATE TO NEXT WAFER 63

MONITOR RGA & ADJUST FLOW → OPEN SHUTTER 58 → DEPOSIT 61 → CLOSE SHUTTER AT DESIRED THICKNESS 62

### SiO2 DEPOSITION 64

DEPOSIT SiO$_2$ TO DESIRED THICKNESS 67 ← ROTATE TO FIRST WAFER AND PRESPUTTER ← ROTATE TO SiO$_2$ TARGET ADJUST O$_2$ FLOW TO PRESPUTTER TARGET 65

68 → ROTATE TO NEXT WAFER → SHUT DOWN SYSTEM 69

66

75

SiO₂ —79

| PR | VOx | | PR | —74 |

Si₃ N₄ —13

Device Layer —73

Si Substrate —12

*Fig. 6a*

80 — Si₃N₄
78

75 — SiO₂

77

79 — VOx
76

NiCr

Si₃N₄ —13

Device/Sacrificial Layer —73

Si Substrate —12

*Fig. 6b*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **Chain E E.** Effects of oxygen in ion-beam sputter deposition of vanadium oxide. *Journal of Vacuum Science and Technology: Part A, American Institute of Physics,* 01 July 1987, vol. 5 (4), ISSN 0734-2101, 1836-1839

- Ion beam sputtering and dual ion beam sputtering of titanium oxide films. **Cevro M et al.** Journal of Physics D. Applied Physics. IOP Publishing, Bristol, 14 September 1995, vol. 28, 1962-1976
- The use of the ion beam current as a process control in the reactive sputtering of zirconium oxide. **Masaaki Yoshitake et al.** Thin Solid Films. Elsevier-Sequoia S.A. Lausanne, 15 July 1993, vol. 230, 48-54